(19) Europäisches Patentamt
European Patent Office
Office européen des brevets

(11) **EP 1 124 251 B1**

(12) **EUROPÄISCHE PATENTSCHRIFT**

(45) Veröffentlichungstag und Bekanntmachung des Hinweises auf die Patenterteilung:
**02.03.2011 Patentblatt 2011/09**

(51) Int Cl.:
*H01J 49/48* *(2006.01)*

(21) Anmeldenummer: **01100857.0**

(22) Anmeldetag: **16.01.2001**

(54) **Elektronenerergiefilter mit magnetischen Umlenkbereichen**

Electron energy filter with magnetic deflection unit

Filtre d'énergie pour faisceau d'électrons avec unité de déflection magnétique

(84) Benannte Vertragsstaaten:
**DE GB NL**

(30) Priorität: **08.02.2000 DE 10005347**

(43) Veröffentlichungstag der Anmeldung:
**16.08.2001 Patentblatt 2001/33**

(73) Patentinhaber: **Carl Zeiss NTS GmbH**
**73447 Oberkochen (DE)**

(72) Erfinder: **Rose, Harald, Prof. Dr.**
**64287 Darmstadt (DE)**

(74) Vertreter: **Gnatzig, Klaus et al**
**Carl Zeiss**
**Patentabteilung**
**73446 Oberkochen (DE)**

(56) Entgegenhaltungen:
EP-A- 0 647 960   EP-A- 0 772 225
EP-A- 0 967 630   EP-A- 1 058 287
DE-A1- 3 532 326   DE-A1- 4 310 559
DE-A1- 19 838 600   US-A- 4 740 704
US-A- 4 760 261   US-A- 5 811 801
US-A- 5 955 732

- PATENT ABSTRACTS OF JAPAN Bd. 1999, Nr. 14, 22. Dezember 1999 (1999-12-22) & JP 11 260312 A (JEOL LTD), 24. September 1999 (1999-09-24) & US 6 307 205 B1 23. Oktober 2001 (2001-10-23)
- PATENT ABSTRACTS OF JAPAN Bd. 1998, Nr. 14, 31. Dezember 1998 (1998-12-31) & JP 10 241627 A (JEOL LTD), 11. September 1998 (1998-09-11) & US 6 097 028 A 1. August 2000 (2000-08-01)
- PATENT ABSTRACTS OF JAPAN Bd. 1999, Nr. 02, 26. Februar 1999 (1999-02-26) & JP 10 302711 A (JEOL LTD), 13. November 1998 (1998-11-13)

**Beschreibung**

Abbildende Elektronenenergiefilter werden bei Transmissionselektronenmikrosköpen verwendet, um den Kontrast der Objektabbildung oder von Beugungsdiagrammen durch die Auswahl von Elektronen eines bestimmten Energiebereiches zu verbessern. Auch die Registrierung von Elementverteilungen und Energieverlustspektren ist mit derartigen Filtersystemen möglich.

Aus der DE 43 10 559, der US 4 740 704 und der US 4 760 261 sind Filtersysteme bekannt, die als dispersive Elemente drei oder vier homogene oder inhomogene Magnetfelder verwenden. Diese Energiefilter sind geradsichtig, d.h. die optischen Achsen der einfallenden und austretenden Elektronenbahnen sind koaxial zueinander. Diese geradsichtigen Energiefilter haben den Vorteil einer relativ einfachen Justierbarkeit, da das gesamte Abbildungssystem vor und hinter dem Energiefilter zunächst bei abgeschaltetem Energiefilter vorjustiert werden kann. Dieser Vorteil wird jedoch durch eine relativ große Bauhöhe des Gesamtsystems aus Elektronenmikroskop und Energiefilter erkauft, da sämtliche elektronenoptischen Komponenten seriell entlang einer geraden optischen Achse angeordnet sind. Daraus können insbesondere bei Elektronenenergien von 200 keV und höher und den bei diesen Energien für eine hohe Dispersion erforderlichen, relativ großen, unsymmetrisch zur Symmetrieachse der elektronenoptischen Säule angeordneten Filtern mechanische Stabilitätsprobleme auftreten.

Darüberhinaus sind beispielsweise aus der US 4 851 670 Energiefilter bekannt, die als dispersives Element einen einzigen Umlenkbereich aufweisen, der eine Strahlumlenkung um 90° bewirkt. Ein einziges dispersives Umlenkelement erzeugt jedoch relativ große Abbildungsfehler, weshalb dem Umlenkelement ein recht aufwendiges Abbildungssystem nachgeschaltet werden muß. Zwar läßt sich durch die 90° Umlenkung der optischen Achse durch das dispersive Element und den anschließenden horizontalen Verlauf der optischen Achse hinter dem Energiefilter die Bauhöhe reduzieren. Jedoch treten auch bei diesem System sehr schnell mechanische Stabilitätsprobleme auf, da das aufwendige optische Abbildungssystem hinter dem Energiefilter unter dem Einfluß der Gravitation zu recht großen Momenten führt.

Aus der DE 198 38 600-A1 sind des weiteren Elektronenenergiefilter bekannt, die ebenfalls eine 90° Gesamtablenkung der optischen Achse zwischen Filtereingang und Filterausgang erzeugen, die jedoch gleichzeitig durch mehrfache Strahlumlenkung in entgegengesetzter Richtung einen symmetrischen Aufbau bezüglich einer Mittenebene aufweisen. Durch den symmetrischen Aufbau des Energiefilters lassen sich bekanntlich einige Abbildungsfehler innerhalb des Energiefilters vermeiden, so daß insgesamt verbesserte Abbildungseigenschaften resultieren. Auch hier führt jedoch der horizontale Verlauf der optischen Achse hinter dem Filterausgang zu mechanischen Stabilitätsproblemen.

Das Ziel der vorliegenden Erfindung ist ein Energiefilter, insbesondere für Elektronenmikroskope, das einerseits eine geringe Bauhöhe des Gesamtsystems aus Elektronenmikroskop mit Energiefilter ermöglicht und andererseits zu möglichst geringen mechanischen Stabilitätsproblemen führt. Ein weiters Ziel der Erfindung ist es, ein Energiefilter anzugeben, bei dem die elektronenoptisch bedingten Abbildungsfehler möglichst klein gehalten werden können.

Das erstgenannte Ziel wird erfindungsgemäß durch ein Energiefilter mit den Merkmalen des Anspruches 1 gelöst. Vorteilhafte Ausführungsformen der Erfindung ergeben sich sowohl aus der Kombination beider Maßnahmen als auch aus den Merkmalen der abhängigen Ansprüche. Insbesondere wird das zweitgenannte Ziel durch ein Energiefilter mit den Merkmalen des Anspruches 2 und 4 gelöst.

Dadurch daß die Gesamtumlenkung der optischen Achse zwischen Filtereingang und Filterausgang mehr als 90° beträgt, ergibt sich bei vertikal nach unten verlaufender optischer Achse vor dem Filtereingang eine schräg nach oben verlaufende optische Achse hinter dem Filterausgang. Durch diese schräg nach oben verlaufende optische Achse hinter dem Filterausgang werden die unter dem Einfluß der Gravitation auftretenden Momente auf die hinter dem Filterausgang angeordneten elektronenoptischen Komponenten reduziert. Eine optimale mechanische Stabilität wird natürlich dann erreicht, wenn die optische Achse hinter dem Filterausgang wieder vertikal verläuft, das Filter insgesamt also eine Strahlumlenkung um 180° erzeugt, wobei Abweichungen des Verlaufs der optischen Achse um +- 30° von einem vertikalen Verlauf die mechanische Stabilität nur geringfügig nachteilig beeinflussen. Die Grenze der maximal möglichen Gesamtumlenkung ist dadurch gegeben, daß der dem Energiefilter nachgeschaltete Detektor nicht oberhalb des Energiefilters im Strahlengang des Elektronenmikroskopes liegen darf und der aus dem Energiefilter austretende Strahlengang auch nicht den in das Energiefilter eintretenden Strahlengang schneiden sollte.

Um neben der mechanischen Stabilität auch die unvermeidbaren elektronenoptischen Abbildungsfehler des Energiefilters gering zu halten, sollte das Energiefilter einerseits symmetrisch zu einer Mittenebene aufgebaut sein und gleichzeitig sollte die Helmholtzlänge mindesten dem doppelten, vorzugsweise mindestens dem dreifachen oder gar mindestens dem fünffachen, des Mittelwertes der Umlenkradien in den Umlenkbereichen entsprechen. Die Helmholtzlänge ist dabei der Abstand zwischen zwei durch das Energiefilter betragsmäßig im Abbildungsmaßstab 1 : 1 abgebildeten Ebenen im oder vor dem eingangsseitigen Bereich des Energiefilters. Eine dieser beiden eingangsseitigen Ebenen, die Eingangsbeugungsebene, wird dabei dispersiv im Abbildungsmaßstab 1 : 1 in die sogenannte Dispersionsebene abgebildet und die zweite dieser beiden Ebenen, die Eingangsbildebene achromatisch im Abbildungsmaßstab 1 : 1 in die sogenannte Ausgangsbildebene abgebildet.

Durch den symmetrischen Aufbau des Energiefilters verschwinden bekanntermaßen ein Teil der Fehler 2. Ordnung des Energiefilters. Durch die Kombination mit einer im Vergleich zu den Umlenkradien - oder dem Mittelwert der Umlenkradien bei unterschiedlichen Umlenkradien - innerhalb des Energiefilters langen Helmholtzlänge ergibt sich innerhalb des Energiefilters ein kleiner Bündeldurchmesser, wodurch wiederum erzielt wird, daß auch die unvermeidbaren Abbildungsfehler höherer Ordnungen gering bleiben.

Eine Helmholtzlänge, die mindestens dem fünffachen des Umlenkradius oder des Mittelwertes der Umlenkradien entspricht, ist dabei besonders für Elektronenmikroskope mit einem Einblickkopf in - Elekktronenausbreitungsrichtung gesehen - vor dem Energiefilter geeignet, da die Helmholtzlänge dann in etwa der üblichen Baulänge des Einblickkopfes, d.h. dem Abstand der letzten Projektivlinse vor dem Einblickkopf und dem Fluoreszenzschirm oder Detektor, entspricht.

Vorzugsweise erfolgt im ersten und letzten Umlenkbereich die Strahlumlenkung um einen Winkel, der größer 135° ist. Das Energiefilter hat aufgrund der damit verbundenen relativ langen Bahnlängen im Magnetfeld eine recht hohe Dispersion.

Weiterhin ist es vorteilhaft, wenn der erste und letzte Umlenkbereich jeweils aus zwei magnetischen Teilbereichen bestehen, die durch eine Driftstrecke voneinander getrennt sind, wobei der Umlenkwinkel im ersten Teilbereich hinter dem Filtereingang und im letzten Teilbereiches vor dem Filterausgang dem Umlenkwinkel der beiden mittleren Teilbereiche entspricht. Gleichzeitig sollte die Driftstrecke zwischen dem zweiten Teilbereich des ersten Umlenkbereiches und dem zweiten Umlenkbereich der Driftstrecke zwischen dem ersten und zweiten Teilbereich des ersten Umlenkbereiches entsprechen. Dadurch läßt sich die Symmetrie des Strahlenganges in jeder der beiden zueinander symmetrischen Hälften des Energiefilters noch einmal erhöhen. Dadurch resultieren insgesamt zusätzlich achsennähere Strahlverläufe und dadurch geringere Fehler höherer Ordnung.

Um ein Höchstmaß an Symmetrie zu erreichen, sollten die beiden mittleren Umlenkbereiche durch eine Driftstrecke voneinander getrennt sein, deren Länge dem doppelten Abstand zwischen der Eingangsbeugungsebene vor dem Energiefilter und der Eintrittskante des ersten Umlenkbereiches entspricht. Das Energiefilter weist dann eine Doppelsymmetrie auf, d.h. jede der beiden zueinander symmetrischen Hälften des Energiefilters ist selbst wieder, zumindest was die fokussierende Wirkung der Magnetfelder in den Sektormagneten angeht, zur Mittenebene der beiden Hälften symmetrisch. Da die von den Magnetfeldern erzeugte Fokussierung jeweils quadratisch zu der durch das betreffende Magnetfeld erzeugten Umlenkung ist, ist es für die Doppelsymmetrie des Energiefilters unbedeutend, wenn die beiden Hälften des Energiefilters selbst nur bis auf ein unterschiedliches Vorzeichen der Umlenkung in sich selbst wieder symmetrisch sind.

Um insgesamt eine hohe Dispersion bei gleichzeitig kompakter Strahlführung zu erreichen, sollte der Umlenkwinkel in jedem der beiden Teilbereiche des ersten Umlenkbereiches - und entsprechend natürlich auch in den beiden dazu symmetrischen Teilbereichen des letzten Umlenkbereiches - größer gleich 90° sein. Der Umlenkwinkel im ersten Teilbereich des ersten Umlenkbereiches beträgt dabei vorzugsweise sogar zwischen 110° und 120°, idealerweise etwa 115°. Die Kombination einer Strahlumlenkung von 115° im ersten Teilbereich mit einer Umlenkung von 90° im zweiten Teilbereich des ersten Umlenkbereiches liefert dabei eine maximale Dispersion. Eine weitere Erhöhung der Umlenkwinkel ist nur noch mit größeren Driftstrecken zwischen den beiden Teilbereichen des ersten Umlenkbereiches realisierbar, da andernfalls Raumprobleme zwischen dem zweiten Umlenkbereich und den elektronenoptischen Komponenten des Elektronenmikroskopes auftreten.

In einer besonders bevorzugten Ausführungsform ist das Energiefilter insgesamt als teleskopisches oder quasi-teleskopisches System ausgebildet. Quasi-teleskopisch ist das Energiefilter dabei, wenn das Verhältnis aus Objektivbrennweite zu Helmholtlänge des Energiefilters in etwa der numerischen Apertur des Objektivs entspricht. Dieses wird erreicht, wenn die Helmholzlänge größer oder gleich dem zehnfachen des Umlenkradius oder dem Mittelwert der Umlenkradien ist. Auch hierdurch, so hat sich gezeigt, lassen sich die insgesamt auftretenden Abbildungsfehler gering halten, da die Abbildungsfehler höherer als 2. Ordnung gering bleiben.

Um die Abbildungsfehler 2. Ordnung insgesamt vollständig zu korrigieren, ist es vorteilhaft, in den Driftstrecken zwischen den einzelnen Umlenkbereichen und Teilbereichen jeweils Hexapole vorzusehen, die natürlich in den beiden symmetrischen Hälften des Energiefilters symmetrisch zueinander anzuordnen sind. Diese Hexapole dienen zur Korrektur der Abbildungsfehler 2. Ordnung.

In einem Teil der Umlenkbereiche, weist das erfindungsgemäße Energiefilter vorzugsweise inhomogene Magnetfelder auf.

Das Energiefilter bildet eine eingangsseitige Ebene, die Eingangsbeugungsebene, dispersiv in eine frei zugängliche ausgangsseitige Ebene, die Dispersionsebene oder Selektionsebene ab. In der Symmetrieebene des Energiefilters entsteht dabei ein Strichfokus, d.h. ein in nur einer Richtung fokussiertes Bild der Eingangsbeugungsebene.

Da das Energiefilter insgesamt als teleskopisches System wirkt, sollte bei Anwendung in einem Transmissionselektronenmikroskop ein reelles Zwischenbild des Objektes oder der Quelle - je nach dem ob ein energiegefiltertes Objektbild oder ein Objektbeugungsdiagramm aufgezeichnet werden soll - in der dem Filter abgewandten Brennebene der letzten vor dem Filter liegenden Elektronenlinse erzeugt sein.

Nachfolgend werden Einzelheiten der Erfindung anhand der in der Figuren dargestellten Ausführungsbeispiele näher erläutert. Im einzelnen zeigen:

Figur 1                     eine schematische Darstellung eines erfindungsgemäßen Energiefilters in Kombination mit einem Transmissionselektronenmikroskop;

Figur 2                     eine vergrößerte schematische Darstellung des Energiefilters aus Figur 1;

Figuren 3a und 3b           die Fundamentalbahnen innerhalb des Energiefilters aus Figur 2 in der Zeichenebene der Figur 2 (Figur 3a) und in der zur Zeichenebene der Figur 2 senkrechten Ebene (Figur 3b);

Figur 3c                    die dispersive Bahn im Energiefilter aus Figur 2;

Figur 4                     eine schematische Darstellung eines weiteren Ausführungsbeispiels eines erfindungsgemäßen Energiefilters,

Figuren 5a - 5c             die Fundamentalbahnen im Energiefilter nach Figur 4, und

Figur 6                     den Schnitt durch ein Energiefilter mit acht Umlenkbereichen und vollständiger Doppelsymmetrie.

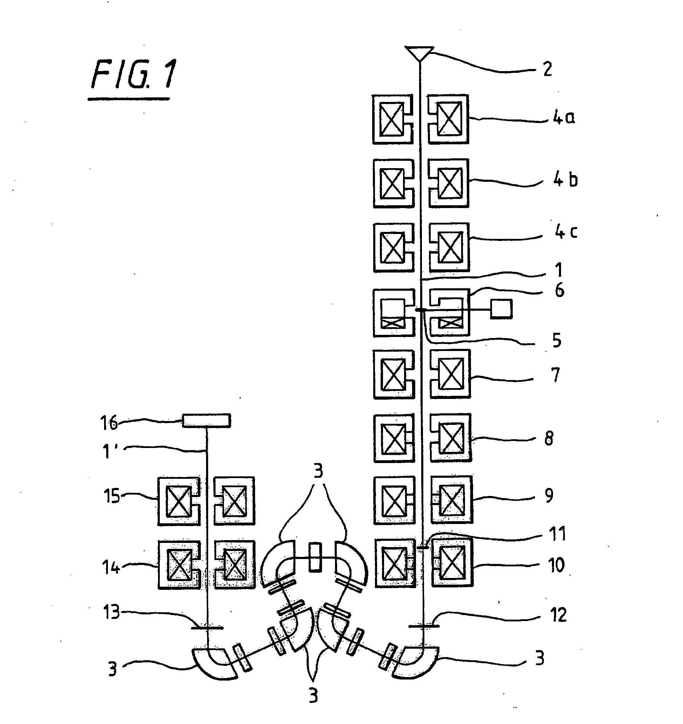

Das in der Figur 1 dargestellte Transmissionselektronenmikroskop hat insgesamt eine Führung der optischen Achse, die im wesentlichen der Linienführung des großen Buchstaben J entspricht. In dem dem Energiefilter (3) - in Strahlrichtung gesehen - vorgeschalteten Teil hat das elektronenoptische Abbildungssystem einen nahezu konventionellen Aufbau mit einer Elektronenquelle (2) und einem mehrstufigen, vorzugsweise vierstufigen Kondensor (4a, 4b, 4c, 6) aus drei einzelnen Magnetlinsen (4a, 4b, 4c) und einer den drei einzelnen Magnetlinsen nachgeschalteten Kondensor-Objektiv-Einfeldlinse (6). Für die Aufnahme eines zu untersuchenden Präparates ist ein Goniometer (5) auf der Höhe des Polschuhspaltes der Kondensor-Objektiv-Einfeldlinse (6) vorgesehen. Die Kondensor-Objektiv-Einfeldlinse erfüllt bei dieser Anordnung eine Doppelfunktion, sie dient einerseits gemeinsam mit den drei zwischen der Teilchenquelle (2) und der Kondensor-Objektiv-Einfeldlinse (6) angeordneten drei einzelnen magnetischen Linsen zur Ausleuchtung der Präparatebene und gleichzeitig als Objektiv zur vergrößerten Abbildung der Präparatebene.

Der Kondensor-Objektiv-Einfeldlinse (6) ist ein mehrstufiges, vorzugsweise aus vier einzelnen Magnetlinsen (7, 8, 9, 10) bestehendes Abbildungssystem nachgeschaltet. Dieses vergrößernde Abbildungssystem (7, 8, 9, 10) wird dabei so betrieben, daß ein Bild der Quelle (2), genauer gesagt der Crossover der Quelle (2), oder die Präparatebene in die Eingangsbeugungsebene (12) des Energiefilters (3) abgebildet wird. Das Energiefilter (3) bildet diese Eingangsbeugungsebene (12) dispersiv stigmatisch in die Selektionsebene (13) ab. Gleichzeitig bildet das elektronenoptische Abbildungssystem (7, 8, 9, 10) entweder den Crossover der Elektronenquelle (2) (bei Objektbeugungsdiagrammen) oder die Präparatebene (bei energiegefilterter Objektabbildung) nach unendlich ab. Das letzte reelle Zwischenbild des Präparates im Falle der Energiegefilterten Objektabbildung - bzw. des Crossovers der Teilchenquelle (2) im Falle der Aufnahme von Objektbeugungsdiagrammen - vor dem Energiefilter (3) entsteht demzufolge in der vom Energiefilter (3) abgewandten Brennebene (11) der letzten vor dem Energiefilter (3) angeordneten Linse (10) des elektronenoptischen Abbildungssystems. Mit anderen Worten, je nach gewünschter Vergrößerung wird die Erregung der letzten vor dem Energiefilter (3) angeordneten Linse (10) so eingestellt, daß je nach Lage des von dem vorgeschalteten vergrößernden Abbildungssystems aus den Elementen (7, 8, 9) erzeugte letzte Zwischenbild mit der Brennebene der letzten vor dem Energiefilter (3) angeordneten Linse (10) zusammenfällt.

Das Energiefilter (3) wirkt als afokales elektronenoptisches System, so daß die parallel eintretenden Strahlen parallel wieder aus dem Energiefilter (3) austreten, d.h. die Helmholtzlänge des Energiefilters ist unendlich. Das Energiefilter (3) lenkt dabei die optische Achse - neben zusätzlichen weiteren Zwischenablenkungen innerhalb des Energiefilters (3) - insgesamt um 180° um, so daß die aus dem Energiefilter (3) austretende optische Achse (1') zur einfallenden optischen Achse (1) parallel versetzt ist. Der Versatz zwischen der eintretenden optischen Achse (1) und der austretenden optischen Achse (1') beträgt dabei vorzugsweise zwischen ca. 0,6 und 1m.

Entlang der wieder vertikal nach oben verlaufenden optischen Achse (1') hinter dem Ausgang des Energiefilters (3) sind zwei weitere Elektronenlinsen (14, 15) vorgesehen, durch die wahlweise entweder im Falle der energiegefilterten Objektabbildung die parallel aus dem Energiefilter (3) austretenden Strahlen auf den Detektor (16) abgebildet werden oder, im Falle der Aufnahme von Objektbeugungsdiagrammen, die Selektionsebene (13) auf den Detektor (16) abgebildet wird. Der Detektor (16) ist dabei als ein- oder zweidimensionaler Elektronendetektor ausgebildet, so daß auch größere Spektren aufgenommen werden können.

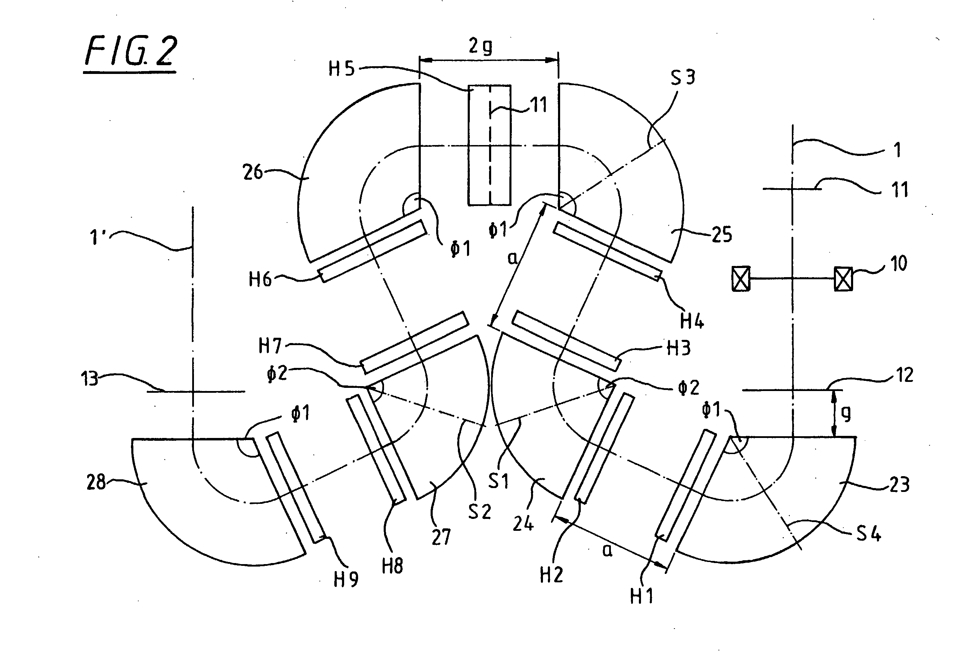

Der Aufbau des Energiefilters (3) ist in der Figur (2) noch einmal vergrößert dargestellt. Das Energiefilter besteht insgesamt aus sechs die optische Achse des Elektronenstrahls ablenkenden Sektormagneten (23, 24, 25, 26, 27, 28), von denen die beiden ersten Sektormagneten (23, 24) einen ersten Umlenkbereich, der dritte Sektormagnet (25) einen zweiten Umlenkbereich, der vierte Sektormagnet (26) einen dritten Umlenkbereich und die beiden letzten Sektormagnete (27, 28) einen vierten Umlenkbereich bilden. Der dritte und vierte Umlenkbereich aus den Sektormagneten (26, 27 und 28) sind dabei spiegelsymmetrisch zu den beiden ersten Umlenkbereichen (23, 24, 25) angeordnet, so daß das Energiefilter insgesamt einen zur Mittenebene (M) symmetrischen Aufbau hat. Falls lediglich der Öffnungsfehler in der Selektionsebene (13) des Energiefilters zu korrigieren ist, können der erste und vierte Umlenkbereich jeweils aus einem einzigen Sekormagnet bestehen. Soweit auch die Korrektur der Abbildungsfehler 2. Ordnung in der Bildebene (16) gewünscht ist, ist es jedoch vorteilhaft, wie in der Figur 2 dargestellt den ersten Umlenkbereich in zwei Teilbereiche (23, 24) mit jeweils einem separaten Sektormagneten und einer dazwischen liegenden Driftstrecke im magnetfeldfreien Raum vorzusehen. Im letzteren Fall ist aufgrund der Symmetrie des Energiefilters natürlich auch eine entsprechende Aufspaltung des vierten und letzten Ablenkbereiches in zwei Sektormagneten (27, 28) vorzusehen.

In der Driftstrecke zwischen den beiden Teilbereichen des ersten Umlenkbereiches sind zwei Hexapolkorrektoren (H1 und H2) und in der Driftstrecke zwischen dem zweiten Teilbereich des ersten Umlenkbereiches und dem zweiten Umlenkbereich sind zwei weitere Hexapolkorrektoren (H3, H4) vorgesehen. Diese Hexapolkorrektoren dienen zur Korrektur der Abbildungsfehler 2. Ordnung in der Endbildeben (16). Aufgrund der Symmetrie zur Mittenebene (M) sind entsprechend zwischen dem dritten Umlenkbereich (26) und dem ersten Teilbereich des letzten Umlenkbereiches (27) zwei weitere Hexapolkorrektoren (H6, H7) und zwischen den beiden Teilbereichen des letzten Umlenkbereiches zwei weitere Hexapolkorrektoren (H8, H9) vorgesehen. Ein weiterer Hexapolkorrektor (H5) ist zwischen dem zweiten Umlenkbereich (25) und dem dritten Umlenkbereich (26) in der Mittenebene (M) angeordnet.

Die Driftstrecke zwischen dem Austritt aus dem zweiten Teilbereich (24) des ersten Umlenkbereiches und dem Eintritt des Elektronenstrahls in den zweiten Umlenkbereich (25) ist bei dem Energiefilter in Figur 2 identisch zu der Driftstrecke zwischen den beiden Teilbereichen (23, 24) des ersten Umlenkbereiches. Außerdem sind gleichzeitig die Umlenkwinkel Φ1 im ersten Teilbereich (23) des ersten Umlenkbereiches und im zweiten Umlenkbereich (25) identisch gewählt. Durch diese beiden Maßnahmen ergibt sich eine weitere Symmetrisierung. Der Aufbau des Energiefilters zwischen der senkrecht zur optischen Achse stehenden Mittenebene (S3) im zweiten Umlenkbereich (25) und der senkrecht zur optischen Achse stehenden Mittenebene (S4) des ersten Teilbereiches (23) des ersten Umlenkbereiches ist damit spiegelsymmetrisch zur senkrecht zur optischen Achse stehenden Mittenebene (S1) des zweiten Teilbereiches (24) des ersten Umlenkbereiches. Aufgrund der Symmetrie des Gesamtfilters (M) ergibt sich natürlich eine analoge Teilsymmetrie relativ zur senkrecht zur optischen Achse stehenden Mittenebene (S2) des ersten Teilbereiches (27) des letzten Umlenkbereiches. Die in jeder Hälfte des Energiefilters verbleibenden Streckenabschnitte zwischen der Eingangsbeugungsebene und der Mittenebene (S4) des ersten Teilbereiches des ersten Umlenkbereiches sowie zwischen der Mittenebene (S3) des zweiten Umlenkbereiches und der Mittenebene (M) unterscheiden sich lediglich hinsichtlich der Umlenkrichtungen, nicht jedoch hinsichtlich der Stärke der Umlenkung. Da die von den Magnetfeldern erzeugte Fokussierung quadratisch zur Umlenkung und damit von der Umlenkrichtung unabhängig ist, ergibt sich für die Bahnverläufe insgesamt in der ersten Hälfte des Energiefilters zusätzlich eine Symmetrie zur Mittenebene (S1) des zweiten Teilbereiches des ersten Umlenkbereiches und in der zweiten Hälfte eine Symmetrie zur Mittenebene (S2) der ersten Teilbereichs des vierten Umlenkbereichs. Das Energielfilter ist damit - bis auf einen Unterschied in den Umlenkrichtungen - doppelsymmetrisch. Durch diese zusätzliche Teilsymmetrie wird zusammen mit der großen Helmholtzlänge bewirkt, daß sämtliche Elektronenbahnen relativ achsennah verlaufen und dadurch Fehler höherer Ordnung gering bleiben.

Ohne die Hexapolkorrektoren (H1 - H8) wären bei dem in der Figur 2 dargestellten Energiefilter die Verzeichnung und der Öffnungsfehler zweiter Ordnung in der Selektionsebene (13) in Figur 1 korrigiert. Durch die zusätzlichen Hexapolkorrektoren (H1-H8) lassen sich sämtliche Fehler zweiter Ordnung sowohl in der achromatischen Bildebene als auch in der Selektionsebene (13) korrigieren.

Der Abstand zwischen dem zweiten Umlenkbereich (25) und dem dritten Umlenkbereich (26) hat zur Erhaltung der Symmetrie den doppelten Abstand, den die Eingangsbeugungsebene (12) von der Eintrittskante des ersten Umlenkbereiches (23) aufweist.

Ein bevorzugtes Ausführungsbeispiel für ein Energiefilter gemäß Figur 2 hat folgende Konstruktionsdaten:

$\kappa 1 = 0{,}7906$
$\kappa 2 = 0{,}7929$
$\mu 1 = 0{,}6123$
$\mu 2 = 0{,}6094$
$g = 0{,}5809\ R$
$a = 1{,}736\ R$
$D = 7{,}296\ R/E0$
$s = 1{,}32\ R$
$A = 8{,}46\ R.$

Dabei ist $\kappa 1$ die normierte dimensionslose magnetische Fokussierstärke senkrecht zur Zeichenebene in Figur 2 des ersten, dritten, vierten und sechsten Sektormagneten (23, 24, 25, 26 und 28), $\mu 1$ die normierte dimensionslose magnetische Fokussierstärke senkrecht zur Zeichenebene in Figur 2 des zweiten und vierten Sektormagneten (24, 27), $\kappa 2$ die normierte dimensionslose magnetische Fokussierstärke in der Zeichenebene in Figur 2 des ersten, dritten, vierten und sechsten Sektormagneten (23, 25, 26 und 28), $\mu 2$ die normierte dimensionslose magnetische Fokussierstärke in der Zeichenebene der Figur 2 des zweiten und vierten Sektormagneten (24, 27), g der Abstand zwischen der dispersiven Ebene (13) und der Austrittskante des letzten Sektormagneten (28) bzw. zwischen der Eingangsbeugungsebene (12) und der Eintrittskante des ersten Sektormagneten (23), a die freie Driftstrecke zwischen den beiden Teilbereichen des ersten Umlenkbereiches (23, 24) und zwischen dem zweiten Teilbereich des ersten Umlenkbereiches und dem zweiten Umlenkbereich (25), D die Dispersion, s der minimale Abstand zwischen den optischen Achsen im zweiten Sektormagneten (24) und vierten Sektormagneten (27) und A der Achsenabstand der beiden optischen Achsen (1, 1') vor Eintritt in das Energiefilter und nach Austritt aus dem Energiefilter. R ist der in sämtlichen Sektormagneten identische Umlenkradius der optischen Achse und E0 ist die Energie der Elektronen, die sich im Energiefilter auf der optischen Achse ausbreiten. Bei dem in der Figur 2 dargestellten Ausführungsbeispiel beträgt der Umlenkwinkel $\Phi 1$ im ersten und dritten Sektormagneten (23, 25) jeweils 115° und im zweiten Sektormagneten (24) 90°.

Die normierte dimensionslosen Quadrupolstärken $\kappa i$ und $\mu i$ sind dabei definiert durch die Beziehungen

$$\kappa i^2 = \sqrt{\frac{2e}{mU}} \left| \Psi_2 \right| R^2 \quad , \mu i^2 = 1 - \kappa i^2$$

In diesen beiden Beziehungen ist R der jeweilige Krümmungsradius der optischen Achse innerhalb der Umlenkmagneten, U die Beschleunigungsspannung der Elektronen, e die Elementarladung und m die Masse der Elektronen. Die magnetische Quadrupolstärke

$$\Psi_2 = - \left. \frac{\partial B}{\partial Y} \right|_{Y=0}$$

ist dabei der Gradient der magnetischen Kraftflußdichte senkrecht zur Mittenebene genommen entlang der optischen Achse.

Die Fokussierstärken $\kappa 1$, $\kappa 2$ und $\mu 1$ und $\mu 2$ können auf zwei verschiedenen Wegen erzielt werden, entweder durch inhomogene Magnetfelder wie in der US 5 449 914 oder in dem Aufsatz von H. Rose, D. Krahl "Electron Optics of Imaging Energie Filters" in Springer Series in Optical Science, Vol. 71, Seiten 57 ff, Springer Verlag 1995 beschrieben oder durch geeignete Wahl der Neigung der Ein- und Austrittskanten der Sektormagneten (23- 28) zur optischen Achse wie beispielsweise in Optik, Vol. 54, No. 3, Seiten 235 - 250 beschrieben.

Bei der in der Figur 2 dargestellten Ausführungsform, bei der sämtliche Ein- und Austrittskanten der Sektormagnete senkrecht zur optischen Achse stehen, bzw. die optische Achse jeweils lokal senkrecht zur Ein- und Austrittskante des jeweiligen Sektormagneten steht, sind der erste Sektormagnet (23) des ersten Umlenkbereiches und beiden mittleren Sektormagnete (25, 26) und der letzte Sektormagnet (28) des letzten Umlenkbereiches konisch entsprechend der US-A 5 449 914 ausgebildet.

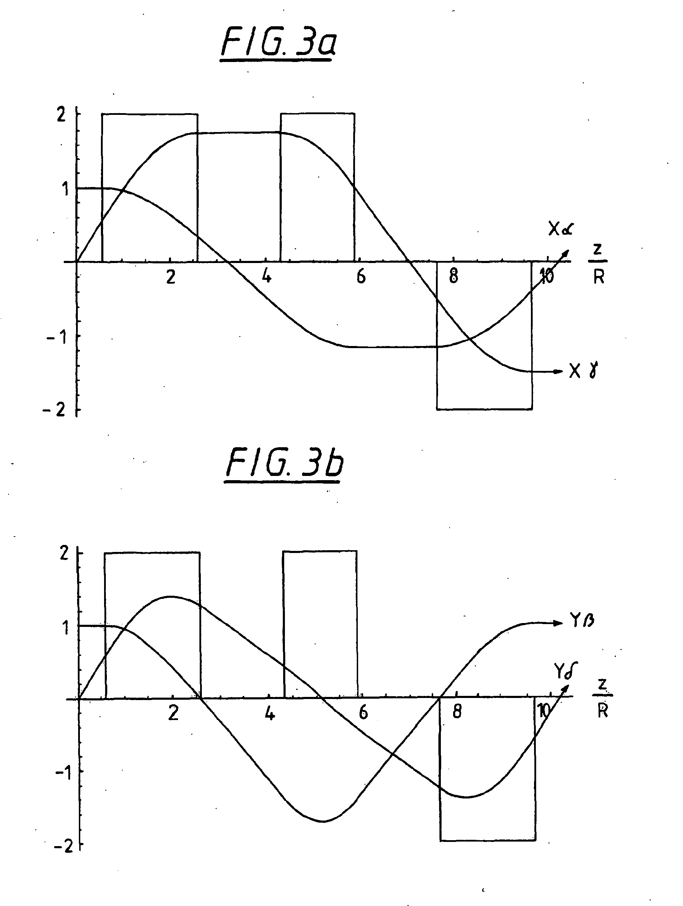

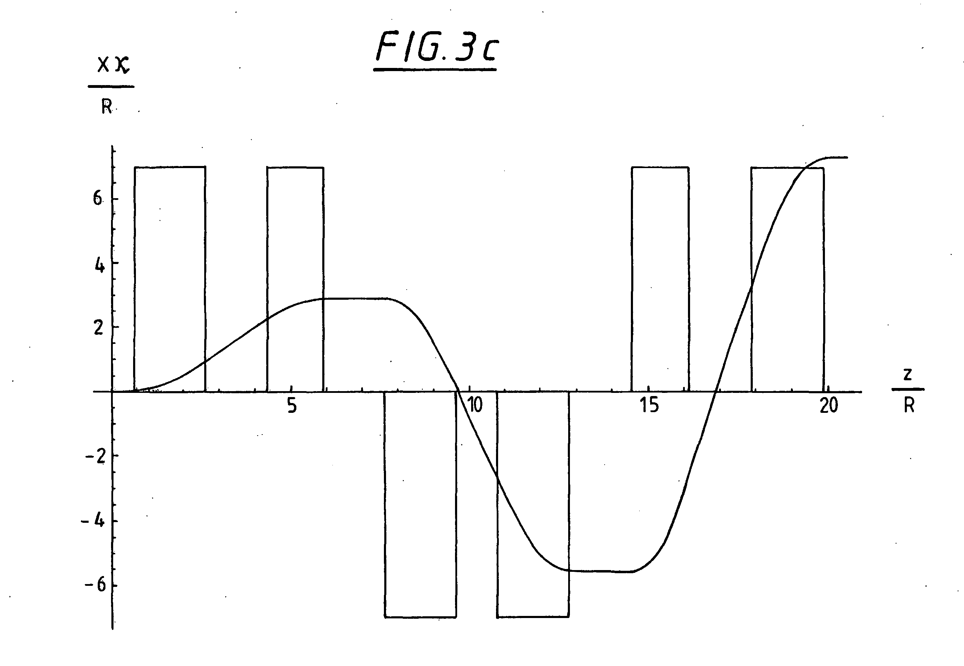

Die Fundamentalbahnen durch ein Energiefilter gemäß Figur 2 mit den oben angegebenen Konstruktionsdaten in der ersten Hälfte des Energiefilters also zwischen der Eingangsbeugungsebene (12) und der Mittenebene (M) sind in den Figuren 3a und 3b für 200 keV Elektronen dargestellt. Der weitere Verlauf der Fundamentalbahnen durch die zweite Hälfte des Energiefilters bis zur Dispersionsebene (13) ergibt sich durch entsprechende Spiegelung des Verlaufs der Fundamentalbahnen in der ersten Hälfte des Energiefilters. Wie man den Fundamentalbahnen in Figuren 3a und 3b entnimmt, entstehen in der Mittenebene (M) zwei Strichfoki, und zwar sowohl ein Strichfokus der Eingangsbeugungsebene (12) als auch ein Strichfokus der Eingangsbildebene (11). Der Strichfokus der Eingangsbeugungsebene in der Mittenebene liegt dabei mit der Strichrichtung in der die optische Achse enthaltenden Ebene, der Strichfokus der Eingangsbildebene liegt dagegen mit der Strichrichtung senkrecht zu der die optische Achse enthaltenden Ebene. Ein weiterer Strichfokus der Eingangsbeugungsebene senkrecht zum x-z-Schnitt, also mit Strichrichtung senkrecht zu der die optische Achse enthaltenden Ebene, entsteht zwischen dem ersten und zweiten Umlenkbereich. Das Energiefilter weist bei einer primären Elektronenenergie von E0 = 200keV bei einem Achsenabstand (A) zwischen der eintrittsseitigen optischen Achse (1) und der austrittsseitigen optischen Achse (1') von 0,6m eine Dispersion von 3,3μm pro eV auf.

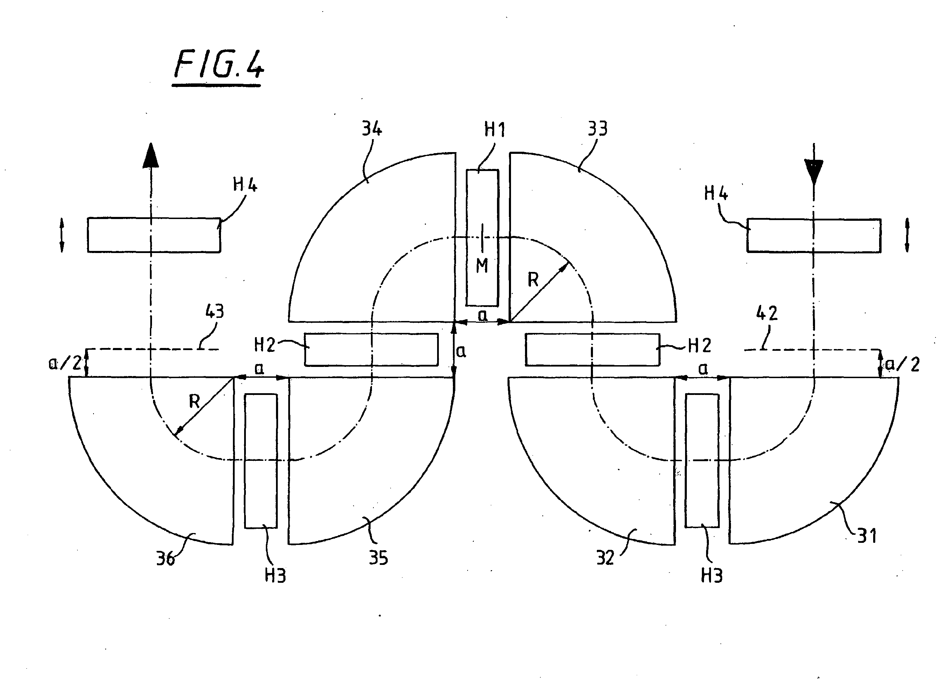

In der Figur 4 ist ein zweites Ausführungsbeispiel der Erfindung dargestellt, das aus sechs Sektormagnete (31 - 36) besteht, die jeweils eine Strahlumlenkung um 90° erzeugen. Auch hier ist das Energiefilter symmetrisch zur Mittenebene (M) aufgebaut. Die beiden ersten Sektormagnete (31, 32) und die beiden letzten Sektormagnete (35, 36) bilden auch hier wieder einen gemeinsamen Umlenkbereich, der in Summe jeweils eine Umlenkung um 180° bewirkt. Die Summe aller sechs Sektormagnete (31 - 36) erzeugt eine Gesamtumlenkung der optischen Achse zwischen der Eingangsseite des Energiefilters und der Ausgangsseite des Energiefilters um 180°. Die Länge der Driftstrecken (a) jeweils zwischen zwei Umlenkbereichen ist bei diesem Ausführungsbeispiel identisch und beträgt jeweils den doppelten Abstand des Abstandes der Dispersionsebene (43) von der Austrittskante des letzten Sektormagneten (36) bzw. dem Abstand zwischen der Eingangsbeugungsebene (42) und der Eintrittskante des ersten Sektormagneten (31). Auch bei diesem Ausführungsbeispiel sind zwischen den Umlenkbereichen jeweils Hexapolkorrektoren (H1 - H3) vorgesehen, die zur Korrektur der Fehler 2. Ordnung im Bild dienen. Zusätzlich sind zwei weitere Hexapolkorrektoren (H4) vor der Eintrittskante des ersten Sektormagneten (31) und hinter der Austrittskante des letzten Sektormagneten (36) vorgesehen.

Auch das in der Figur 4 dargestellte Energiefilter ist doppelsymmetrisch, d.h. jede der beiden symmetrischen Hälften ist in sich wiederum - bis auf einen Unterschied hinsichtlich der Umlenkrichtungen - symmetrisch zur senkrecht zur optischen Achse stehenden Mittenebnen des zweiten Sektormagneten (32) bzw. des fünften Sektormagneten (35) aufgebaut.

Ein solches Energiefilter kann folgende Konstruktionsdaten aufweisen:

magnetische Fokussierstärke der Sektormagneten senkrecht zur Zeichenebene (yz-Schnitt):

$\kappa$ = 0,5573 ,
magnetische Fokussierstärke in der Zeichenebene (xz-Schnitt): $\mu$ = 0,8303 ,
Dispersion D = 4,351 R/ E0,
freie Driftstrecke zwischen den Sektormagnet a = 0,6577 R.

R ist dabei wiederum der in allen sechs Sektormagneten identische Umlenkradius für die optische Achse. Ein solches Energiefilter hat bei einem Abstand A = 8R = 0,6 m zwischen der eintrittsseitigen optischen Achse und der austrittsseitigen optischen Achse eine Dispersion von 1,95$\mu$m pro eV bei einer Energie der Elektronen von E0 = 200keV.

Bei dem in der Figur 4 dargestellten Ausführungsbeispiel, bei dem die optische Achse jeweils an den Ein- und Austrittskanten der einzelnen Sektormagneten (31 - 36) senkrecht zu den Ein- und Austrittskanten verläuft, werden die magnetischen Fokussierstärken wiederum durch entsprechende inhomogene Magnetfelder erzeugt.

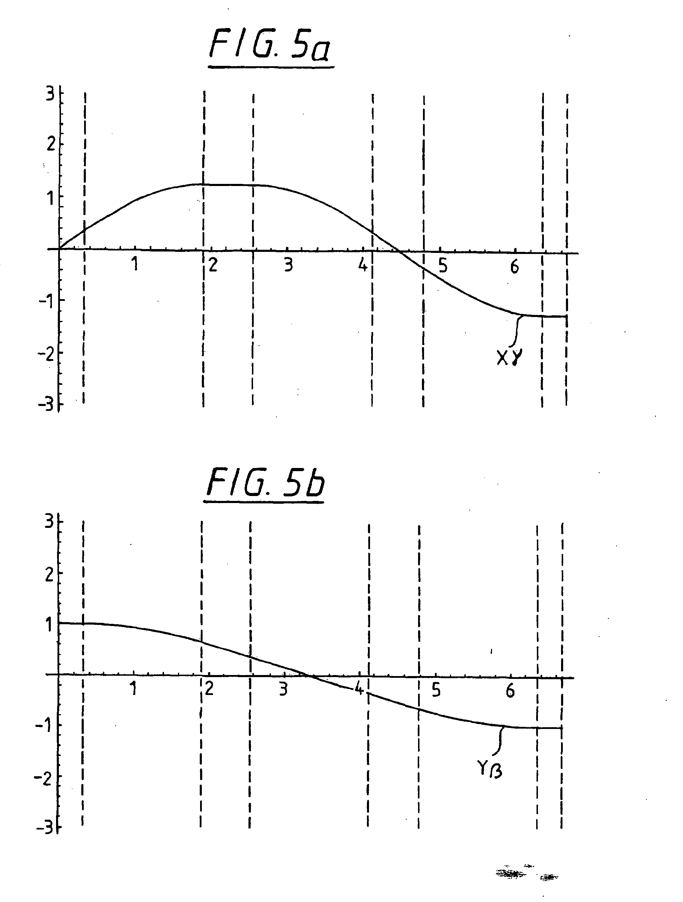

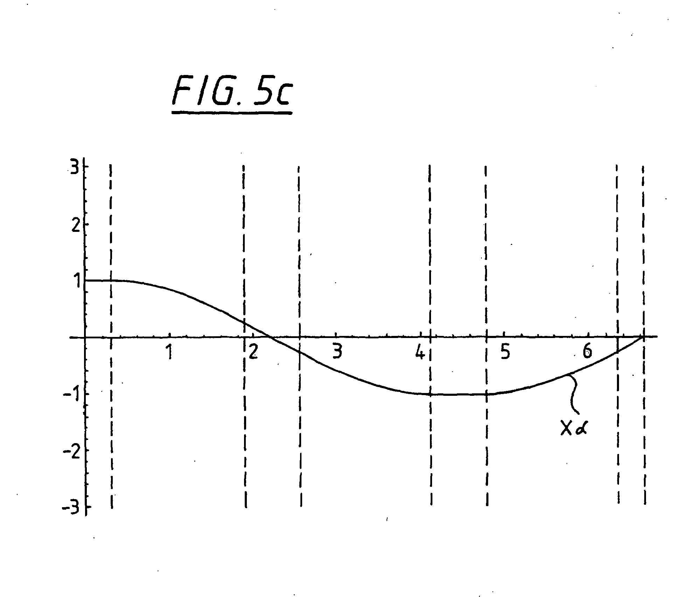

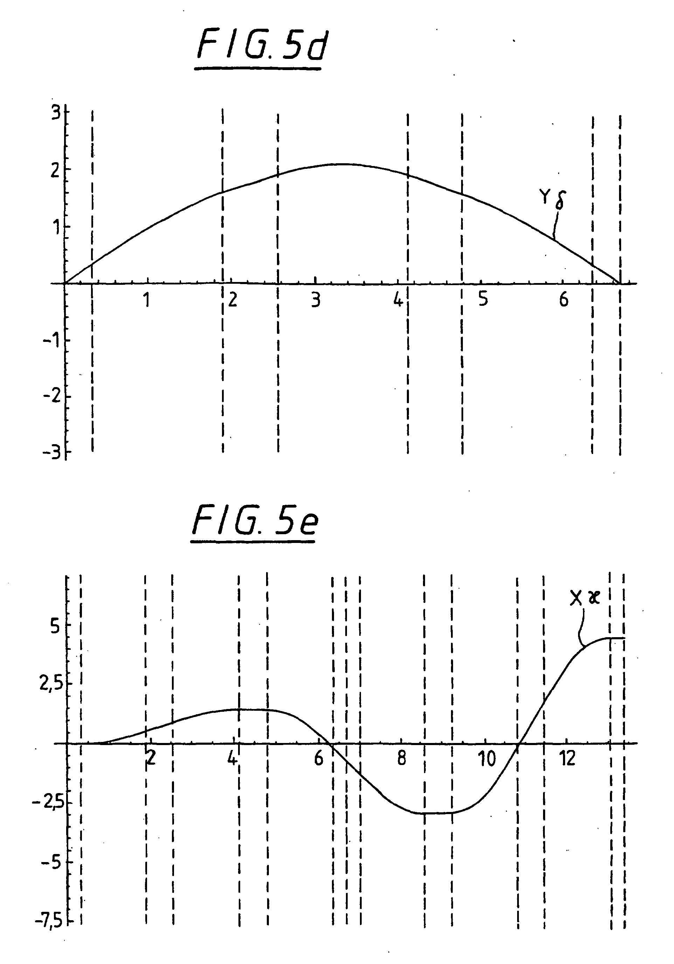

Die Verläufe der Fundamentalbahnen jeweils in der ersten Hälfte des Energiefilters, also zwischen der Eingangsbeugungsebene (42) und der Mittenebene (M) sind in den Figuren 5a-5d dargestellt. Die dispersive Bahn x$\kappa$ ist in der Figur 5e dargestellt. Wie man auch hier den Fundamentalbahnen entnimmt, entstehen auch bei diesem Energiefilter in der Mittenebene zwei Strichfoki, und zwar ein Strichfokus der Bildebene und ein weiterer Strichfokus der Eingangsbeugungsebene.

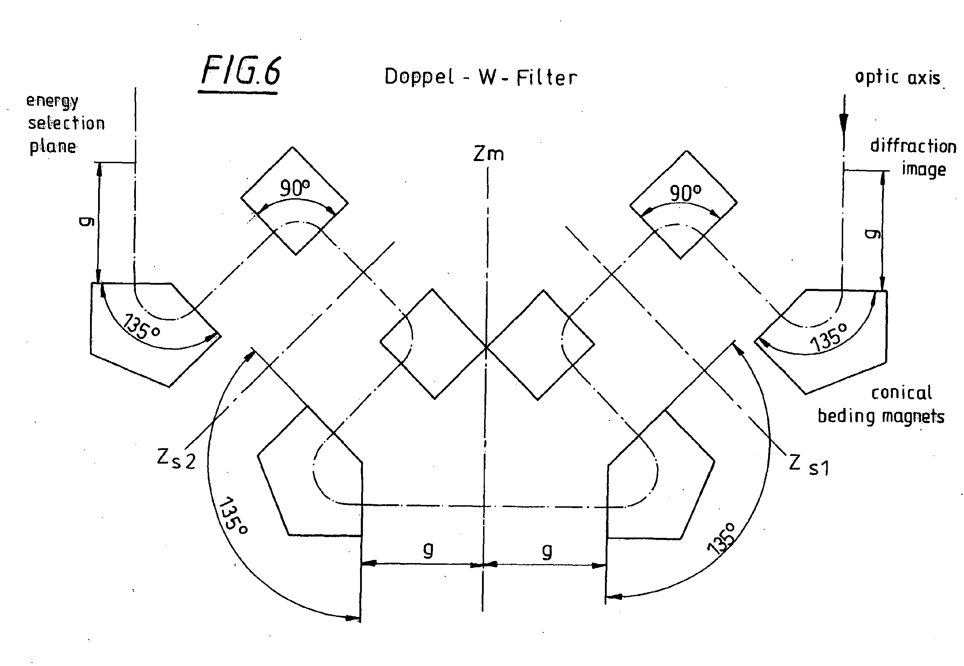

Das in der Figur 6 dargestellte Energiefilter weist insgesamt acht Sektormagnete auf, von denen - in Strahlrichtung gesehen - der erste, vierte, fünfte, und achte Sektormagnet jeweils eine Umlenkung um 135° und die verbleibenden Sektormagnete jeweils eine Umlenkung um 90° bewirken. Die Gesamtumlenkung der optischen Achse beträgt auch bei diesem Beispiel 180°. Das Energiefilter ist symmetrisch zu einer Mittenebene (Zm) und jede der beiden zueinander symmetrischen Hälften symmetrisch zu jeweils einer Symmetrieebene (Zs1, Zs2) aufgebaut, so daß auch dieses Energiefilter eine Doppelsymmetrie aufweist. Es besteht im Grunde aus zwei hintereinander geschalteten Energiefiltern, die jedes für sich eine Umlenkung der optischen Achse um 90° bewirken.

Bei den anhand der Figuren 2 und 4 beschriebenen Ausführungsbeispielen ist die Helmholtzlänge jeweils unendlich. Die mit der Erfindung beabsichtigten Erfolge lassen sich jedoch auch dann zufriedenstellend erzielen, wenn kürzere Helmholtzlängen realisiert werden, solange diese noch hinreichend groß gegenüber den Umlenkradien sind.

Bei den beiden anhand der Figuren beschriebenen Ausführungsbeispielen sind die Umlenkradien in allen Sektormagneten jeweils identisch. Es ist jedoch auch unter Einhaltung der Doppelsymmetrie möglich unterschiedliche Umlenkradien zu wählen. Die Doppelsymmetrie läßt sich beispielsweise auch einhalten, wenn bei dem Ausführungsbeispiel in Figur 2 die Umlenkradien im zweiten Teilbereich (24) des ersten Umlenkbereiches und im ersten Teilbereich des dritten Umlenkbereiches (27) gleich aber verschieden zu den Umlenkradien in den übrigen Umlenkbereichen (25, 26) und Teilbereichen (23, 28) ist.

Das Energiefilter nach der Erfindung findet bevorzugt als sogenanntes "In-Column-Filter" Anwendung, das in die Säule des Elektronenmikroskopes integriert ist und hinter dem Energiefilter eine Nachvergrößerung um einen Faktor von mindestens 100x aufweist. Denkbar ist jedoch auch ein Einsatz als sogenanntes "Post-Column-Filter" mit einer nur noch schwachen Nachvergrößerung hinter dem Ausgang des Energiefilters.

**Patentansprüche**

1. Elektronenenergiefilter mit magnetischen Umlenkbereichen (3, 23 - 28, 31 - 36), die eine optische Achse (1) am Eingang des Energiefilters in eine optischen Achse (1') am Ausgang des Energiefilters umlenken, und wobei die Umlenkbereiche einen ersten Umlenkbereich (23, 24), einen zweiten Umlenkbereich (25), einen dritten Umlenkbereich (26) und einen vierten Umlenkbereich (27, 28) aufweisen, **dadurch gekennzeichnet, dass** alle Umlenkbereiche (3, 23 - 28, 31 - 36) gemeinsam eine gesamte Strahlumlenkung um einen Winkel zwischen 150° und 210° erzeugen und dass der erste Umlenkbereich (23, 24) und der vierte Umlenkbereich jeweils zweiteilig aus zwei Teilbereichen (23, 24, 27, 28) mit jeweils einer Driftstrecke im magnetfeldfreien Raum zwischen den Teilbereichen (23, 24, 27, 28) ausgebildet sind.

2. Elektronenenergiefilter nach Anspruch 1, wobei die magnetischen Umlenkbereiche (3, 23 - 28, 31 - 36) symmetrisch zu einer Mittenebene (M) angeordnet sind.

3. Elektronenenergiefilter nach Anspruch 2, wobei der erste Umlenkbereich (23, 24) und der zweite Umlenkbereich (25) bis auf eine Richtungsumkehr für die durch den Energiefilter durchlaufenden Elektronen symmetrisch zu einer Symmetrieebene (S1) aufgebildet sind.

4. Elektronenenergiefilter nach einem der Ansprüche 1 bis 3, wobei die Helmholtzlänge des Energiefilters größer als das doppelte des Mittelwertes der Umlenkradien in den Umlenkbereichen ist.

5. Elektronenergiefilter nach Anspruch 4, wobei die Helmholtzlänge des Energiefilters größer als das dreifache, vorzugsweise größer als das fünffache, des Mittelwertes der Umlenkradien in den Umlenkbereichen ist.

6. Elektronenenergiefilter nach einem der Ansprüche 1 bis 5, wobei der Energiefilter teleskopisch oder quasi-teleskopisch ist.

7. Elektronenenergiefilter nach einem der Ansprüche 2 - 6, wobei zwischen dem zweiten Umlenkbereich (25, 33) und dem dritten Umlenkbereich (26, 34) eine Driftstrecke im magnetfeldfreien Raum vorgesehen ist.

8. Elektronenenergiefilter nach Anspruch 7, wobei die Driftstrecke zwischen dem zweiten Umlenkbereich (25, 33) und dem dritten Umlenkbereich (26, 34) eine Länge aufweist, die dem doppelten Abstand (g) zwischen der eingangsseitigen Beugungsebene (12) und der Eintrittskante des ersten Umlenkbereiches (23) entspricht.

9. Elektronenenergiefilter nach einem der Ansprüche 2 bis 8, wobei der Umlenkwinkel $\Phi 1$ des ersten Teilbereiches (23) des ersten Umlenkbereiches betragsmäßig gleich dem Umlenkwinkel $\Phi 1$ des zweiten Umlenkbereichs (25, 33) ist.

10. Elektronenenergiefilter nach einem der Ansprüche 2 - 9, wobei die Länge der Driftstrecke zwischen den beiden Teilbereichen (23, 24) des ersten Umlenkbereiches gleich der Länge der Driftstrecke zwischen dem Austritt aus dem ersten Umlenkbereich und dem Eintritt in den zweiten Umlenkbereich (25; 33) ist.

11. Elektronenenergiefilter nach einem der Ansprüche 2 - 10, wobei der Umlenkwinkel ($\Phi 1$, $\Phi 2$) jeder der beiden Teilbereiche (23, 24) des ersten Umlenkbereiches größer gleich 90° ist.

12. Elektronenenergiefilter nach Anspruch 11, wobei der Umlenkwinkel des ersten Teilbereiches (23) des ersten Umlenkbereiches einen Wert zwischen 110° und 120°, vorzugsweise von 115° aufweist.

13. Elektronenenergiefilter nach einem der Ansprüche 2 - 12, wobei zwischen den Umlenkbereichen (23 - 28; 31 - 36) Hexapolkorrektoren angeordnet sind.

14. Elektronenenergiefilter nach einem der Ansprüche 1 - 13, wobei der Filter ein afokales teleskopisches System ist.

15. Elektronenenergiefilter nach einem der Ansprüche 1 - 14, wobei ein Teil der Umlenkbereiche (23 - 28; 31 - 36) inhomogene Magnetfelder aufweist.

16. Elektronenmikroskop mit einem Energiefilter nach einem der Ansprüche 1 - 15.

**17.** Elektronenmikroskop nach Anspruch 16, wobei ein reelles Zwischenbild des Objektes oder der Quelle (1) in der dem Filter abgewandten Brennebene (11) der letzten dem Filter vorgeschalteten Elektronenlinse (10) erzeugt ist.

**Claims**

**1.** Electron energy filter with magnetic deflection regions (3, 23-28, 31-36) which deflect an optical axis (1) at the input of the energy filter into an optical axis (1') at the output of the energy filter, and the deflection regions having a first deflection region (23, 24), a second deflection region (25), a third deflection region (26) and a fourth deflection region (27, 28), **characterized in that** all the deflection regions (3, 23-28, 31-36) together generate a total beam deflection an angle between 150° and 210°, and **in that** the first deflection region (23, 24) and the fourth deflection region are respectively formed in two parts from two subregions (23, 24, 27, 28) with in each case a drift path in the space free from magnetic fields between the subregions (23, 24, 27, 28).

**2.** Electron energy filter according to Claim 1, in which the magnetic deflection regions (3, 23-28, 31-36) are arranged symmetrically in relation to a middle plane (M).

**3.** Electron energy filter according to Claim 2, in which the first deflection region (23, 24) and the second deflection region (25) are formed symmetrically in relation to a plane (S1) of symmetry as far as a change in direction for the electrons traversing the energy filter.

**4.** Electron energy filter according to one of Claims 1 to 3, in which the Helmholtz length of the energy filter is larger than twice the mean value of the deflection radii in the deflection regions.

**5.** Electron energy filter according to Claim 4, in which the Helmholtz length of the energy filter is larger than three times, preferably larger than five times, the mean value of the deflection radii in the deflection regions.

**6.** Electron energy filter according to one of Claims 1 to 5, in which the energy filter is telescopic or quasi-telescopic.

**7.** Electron energy filter according to one of Claims 2-6, in which a drift path is provided in the space free from magnetic fields between the second deflection region (25, 33) and the third deflection region (26, 34).

**8.** Electron energy filter according to Claim 7, in which the drift path between the second deflection region (25, 33) and the third deflection region (26, 34) has a length which corresponds to twice the spacing (g) between the input-side diffraction plane (12) and the entry edge of the first deflection region (23).

**9.** Electron energy filter according to one of Claims 2 to 8, in which the deflection angle $\Phi 1$ of the first subregion (23) of the first deflection region is equal in absolute value to the deflection angle $\Phi 1$ of the second deflection region (25, 33).

**10.** Electron energy filter according to one of Claims 2-9, in which the length of the drift path between the two subregions (23, 24) of the first deflection region is equal to the length of the drift path between the exit from the first deflection region and the entrance to the second deflection region (25, 33).

**11.** Electron energy filter according to one of Claims 2-10, in which the deflection angle ($\Phi 1$, $\Phi 2$) of each of the two subregions (23, 24) of the first deflection region is greater than or equal to 90°.

**12.** Electron energy filter according to Claim 11, in which the deflection angle of the first subregion (23) of the first deflection region has a value between 110° and 120°, preferably of 115°.

**13.** Electron energy filter according to one of Claims 2-12, in which hexapole correctors are arranged between the deflection regions (23-28; 31-36).

**14.** Electron energy filter according to one of Claims 1-13, in which the filter is an afocal telescopic system.

**15.** Electron energy filter according to one of Claims 1-14, in which some of the deflection regions (23-28; 31-36) have inhomogeneous magnetic fields.

**16.** Electron microscope with an energy filter according to one of Claims 1-15.

**17.** Electron microscope according to Claim 16, in which a real intermediate image of the object or of the source (1) is produced in the focal plane (11), averted from the filter, of the last electron lens (10) upstream of the filter.

**Revendications**

**1.** Filtre d'énergie pour faisceau d'électrons avec des zones de déflection magnétique (3, 23-28, 31-36), qui défléchissent un axe optique (1) à l'entrée du filtre d'énergie en un axe optique (1') à la sortie du filtre d'énergie, et dans lequel les zones de déflection comportent une première zone de déflection (23, 24), une deuxième zone de déflection (25), une troisième zone de déflection (26) et une quatrième zone de déflection (27, 28), **caractérisé en ce que** toutes les zones de déflection (3, 23-28, 31-36) génèrent collectivement une déflection totale du faisceau d'un angle compris entre 150° et 210° et **en ce que** la première zone de déflection (23, 24) et la quatrième zone de déflection sont respectivement réalisées en deux parties sous la forme de deux zones partielles (23, 24, 27, 28) avec respectivement un trajet de dérive dans l'espace sans champ magnétique entre les zones partielles (23, 24, 27, 28).

**2.** Filtre d'énergie pour faisceau d'électrons selon la revendication 1, dans lequel les zones de déflection magnétique (3, 23-28, 31-36) sont disposées symétriquement par rapport à un plan milieu (M).

**3.** Filtre d'énergie pour faisceau d'électrons selon la revendication 2, dans lequel la première zone de déflection (23, 24) et la deuxième zone de déflection (25) sont formées symétriquement par rapport à un plan de symétrie (S1) jusqu'à une inversion du sens pour les électrons traversant le filtre d'énergie.

**4.** Filtre d'énergie pour faisceau d'électrons selon une des revendications 1 à 3, dans lequel la longueur de Helmholtz du filtre d'énergie est supérieure au double de la valeur moyenne des rayons de déflection dans les zones de déflection.

**5.** Filtre d'énergie pour faisceau d'électrons selon la revendication 4, dans lequel la longueur de Helmholtz du filtre d'énergie est supérieure au triple, de préférence supérieure au quintuple de la valeur moyenne des rayons de déflection dans les zones de déflection.

**6.** Filtre d'énergie pour faisceau d'électrons selon une des revendications 1 à 5, dans lequel le filtre d'énergie est télescopique ou quasi-télescopique.

**7.** Filtre d'énergie pour faisceau d'électrons selon une des revendications 2 - 6, dans lequel on a prévu un trajet de dérive dans l'espace sans champ magnétique entre la deuxième zone de déflection (25, 33) et la troisième zone de déflection (26, 34).

**8.** Filtre d'énergie pour faisceau d'électrons selon la revendication 7, dans lequel le trajet de dérive entre la deuxième zone de déflection (25, 33) et la troisième zone de déflection (26, 34) présente une longueur correspondant au double de la distance (g) entre le plan de courbure du côté de l'entrée (12) et le bord d'entrée de la première zone de déflection (23).

**9.** Filtre d'énergie pour faisceau d'électrons selon une des revendications 2 à 8, dans lequel l'angle de déflection $\Phi 1$ de la première zone partielle (23) de la première zone de déflection a la même valeur que l'angle de déflection $\Phi 1$ de la deuxième zone de déflection (25, 33).

**10.** Filtre d'énergie pour faisceau d'électrons selon une des revendications 2 à 9, dans lequel la longueur du trajet de dérive entre les deux zones partielles (23, 24) de la première zone de déflection est égale à la longueur du trajet de dérive entre la sortie de la première zone de déflection et l'entrée dans la deuxième zone de déflection (25, 33).

**11.** Filtre d'énergie pour faisceau d'électrons selon une des revendications 2 à 10, dans lequel l'angle de déflection ($\Phi 1$, $\Phi 2$) de chacune des deux zones partielles (23, 24) de la première zone de déflection est supérieur ou égal à 90°.

**12.** Filtre d'énergie pour faisceau d'électrons selon la revendication 11, dans lequel l'angle de déflection de la première zone partielle (23) de la première zone de déflection présente une valeur comprise entre 110° et 120°, de préférence de 115°.

**13.** Filtre d'énergie pour faisceau d'électrons selon une des revendications 2 - 12, dans lequel des correcteurs hexapolaires sont disposés entre les zones de déflection (23-28 ; 31-36).

**14.** Filtre d'énergie pour faisceau d'électrons selon une des revendications 1 - 13, dans lequel le filtre est un système télescopique afocal.

**15.** Filtre d'énergie pour faisceau d'électrons selon une des revendications 1 - 14, dans lequel une partie des zones de déflection (23-28 ; 31-36) présente un champ magnétique inhomogène.

**16.** Microscope électronique avec un filtre d'énergie selon une des revendications 1 - 15.

**17.** Microscope électronique selon la revendication 16, dans lequel on crée une image réelle intermédiaire de l'objet ou de la source (1) dans le plan focal (11) éloigné du filtre de la dernière lentille électronique (10) branchée avant le filtre.

FIG. 1

FIG.2

EP 1 124 251 B1

## FIG. 3a

## FIG. 3b

FIG.3c

EP 1 124 251 B1

FIG.4

## FIG. 5a

## FIG. 5b

# FIG. 5c

# FIG.5d

# FIG.5e

# FIG.6    Doppel - W - Filter

energy selection plane

optic axis

diffraction image

Zm

90°    90°

135°    135°

Zs2    Zs1

135°    135°

conical beding magnets

g    g    g    g

EP 1 124 251 B1

**EP 1 124 251 B1**

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 4310559
- US 4740704 A
- US 4760261 A

- US 4851670 A
- DE 19838600 A1
- US 5449914 A


**In der Beschreibung aufgeführte Nicht-Patentliteratur**

- Electron Optics of Imaging Energie Filters. **H. Rose ; D. Krahl.** Springer Series in Optical Science. Springer Verlag, vol. 71, 57 ff

- *Optik,* vol. 54 (3), 235-250